# EUROPÄISCHE PATENTSCHRIFT

(11) **EP 1 535 318 B1**
(45) Veröffentlichungstag und Bekanntmachung des Hinweises auf die Patenterteilung: **08.06.2011**
(21) Anmeldenummer: 03798875.5
(22) Anmeldetag: 08.08.2003
(51) Int. Cl.: H01L 21/306, H01L 31/0236, C09K 13/02, C09K 13/06

(54) **ÄTZPASTEN FÜR SILIZIUMOBERFLÄCHEN UND -SCHICHTEN**
ETCHING PASTES FOR SILICON SURFACES AND LAYERS
PATES DE GRAVURE POUR SURFACES ET COUCHES DE SILICIUM

(30) Priorität: 04.09.2002 DE 10241300
(43) Veröffentlichungstag der Anmeldung: 01.06.2005
(73) Patentinhaber: Merck Patent GmbH, 64293 Darmstadt (DE)
(72) Erfinder: KÜBELBECK, Armin, 64625 Bensheim (DE); KLEIN, Sylke, 64380 Rossdorf (DE); STOCKUM, Werner, 64354 Reinheim (DE)
(86) Internationale Anmeldenummer: PCT/EP2003/008805
(87) Internationale Veröffentlichungsnummer: WO 2004/032218

(56) Entgegenhaltungen:
- EP-A- 0 246 536
- EP-A- 0 944 114
- WO-A-01/83391
- DE-A- 10 014 445
- US-A- 4 448 637
- US-A- 5 688 366

## Beschreibung

Die vorliegende Erfindung betrifft neue Ätzmedien in Form von Ätzpasten zum ganzflächigen und selektiven Ätzen von Siliziumoberflächen und -schichten sowie deren Verwendung.

### Stand der Technik

Siliziumoberflächen und -schichten werden in der Photovoltaik-, Elektronik- und Halbleiterindustrie oft nasschemisch in Tauchbädern geätzt. Diese ganzflächige Ätzung kann dabei entweder im sauren (isotrope Ätzung) oder im alkalischen Medium (anisotrope Ätzung) erfolgen. Im Sauren werden häufig Mischungen von Flusssäure und Salpetersäure, im Alkalischen starke Basen wie Natronlauge, Kalilauge, Tetramethylammoniumhydroxid (TMAH), usw. verwendet.

Um neben der ganzflächigen Ätzung (z.B. Polierätze, Texturätze) definierte, feine Ätzmuster/ -strukturen (z.B. für vergrabene Strukturen) zu erzeugen, sind vor dem eigentlichen Ätzschritt materialintensive, zeit- und kostenaufwendige Prozessschritte notwendig wie z.B. der dem Fachmann bekannte fotolithografische Maskierungsprozess.

Bei einem solchen Maskierungsprozess geht man von einem Siliziumwafer aus. Auf diesem wird durch thermische Oxidation eine dichte Oxidschicht erzeugt und wie folgt strukturiert.

Durch Beschichtung mit einem Photoresist, Trocknen, Belichten mit UV-Licht und einer Photomaske, und anschließendem Entwickeln, wird das Oxid an den gewünschten Stellen freigelegt und danach mit Flusssäure entfernt. Anschließend wird der noch verbleibende Photoresist beispielsweise mit einem Lösungsmittel entfernt ("gestrippt"). Der so mit einer Oxidmaske versehene Si-Wafer kann nun in einer starken Base, wie z.B. 30%ige KOH, selektiv an den Stellen geätzt werden, die nicht vom Oxid bedeckt werden. Die Oxidmaske ist gegenüber der Base beständig. Nach erfolgter selektiver Ätzung des Siliziums wird die Oxidmaske meist mit Flusssäure wieder entfernt.

Solche lithografischen Verfahren werden in der industriellen Solarzellenherstellung aus Kostengründen nicht angewendet [1]. Das selektive Strukturieren/Öffnen der Siliziumoberfläche bzw. -schicht ist jedoch durch folgende Prozessführung notwendig.

Im Herstellprozess einer Standard-Siliziumsolarzelle wird auf einem p-dotierten Wafer durch z.B. eine Gasdiffusion im POCl₃-Ofen der für den fotoelektrischen Effekt notwendige p-n-Übergang gebildet. Dabei entsteht um den gesamten Wafer eine ca. 500 nm dicke, n-dotierte Siliziumschicht, die für die spätere fotovoltaische Anwendung partiell geöffnet/aufgetrennt werden muss.

Diese Öffnung kann mechanisch, durch Laser-cutting oder Trockenätzverfahren wie das Plasmaätzen erfolgen.

Die Nachteile der mechanischen Auftrennung, z.B. des Abschleifens der Zellkanten im letzten Schritt des Herstellprozesses (nach der Metallisierung), bestehen in erheblichen Materialverlusten an Silizium (und Metallpaste), dem mechanischen Stress und der Erzeugung von Kristalldefekten in der Solarzelle.

Das Plasmaätzen erfolgt mit fluorierten Kohlenwasserstoffen, z.B. mit CF₄- oder C₂F₆- Gas in teuren Vakuumanlagen. Dabei werden die Zellen vorher gestapelt und in der Plasmaätzanlage an den Zellkanten geätzt. In diesem Prozess kommt es zu erheblichen Handlingsproblemen beim Stapeln und zu hohen Wafer-Bruchraten. Diese technologischen Probleme werden sich zukünftig noch verschärfen, da man bestrebt ist, auf Grund hoher Materialkosten immer dünnere polykristalline Silizium-Ausgangssubstrate (< 200 µm) gegenüber den heute üblichen Substratdicken von 250-330 µm zu verwenden.

Das Auftrennen des p-n-Übergangs per Laser ist, bedingt durch die notwendige lineare (XY) Bewegung der punktförmigen Laser-Quelle, ein zeitaufwendiges, den Durchsatz limitierendes Verfahren. Die Investitionskosten erheblich. Zudem werden lokale Kristalldefekte erzeugt.

In den gegenwärtig nur im Labormaßstab entwickelten und angewendeten teuren Verfahren zur Erzeugung eines selektiven Emitters wird die bereits oben beschriebene lithografische Oxidmaskierung angewendet. Das Oxid maskiert den Wafer so, dass die Bereiche, auf denen später die Kontakte liegen, frei bleiben. Der maskierte Wafer wird einer Phosphordiffusion unterzogen und in den nicht maskierten Bereichen n⁺⁺-dotiert. Nach der Entfernung der Oxidmaske wird der gesamte Wafer n⁺-dotiert [2].

Dadurch erhält man einer Solarzelle mit selektivem Emitter, d.h. mit 2-3 µm tiefen, hochdotierten n⁺⁺-Bereichen (Bereiche ohne Oxidmaske und später unter den Kontakten liegend) einer Dotierkonzentrationen von ca. 1*10²⁰ cm⁻³ und einem flachen (0.5-1 µm) n⁺-dotierten Emitter über die gesamte Solarzelle mit einer Dotierkonzentration von ca. 1*10¹⁹ cm⁻³.

Die Alternative zur Lithografie ist die Nutzung der siebgedruckten Kontaktlinien als Ätzmaske. Es wird sowohl das nasschemische als auch das plasmachemische Ätzen in der Literatur beschrieben. Nachteilig sind beim Dip (Tauchen) der siebgedruckten Solarzelle in eine Mischung aus HF/HNO₃ - neben dem beabsichtigten Siliziumabtrag zwischen den Kontaktlinien - der Angriff des Siliziums unter den Kontaktlinien und die Ätzschäden in den Metallkontaktlinien selbst. Dadurch kommt es zur rapiden Verschlechterung des Füllfaktors [3].

Das plasmachemischen Ätzen (Reactive Ion Etching, RIE) erfolgt mit Gasen wie z.B. SF₆ bzw. SF₆/O₂ in teuren Vakuumanlagen und unter erheblichen technologischen Optimierungsaufwand des Prozesses [4], [5], [6].

Neben der Bildung des selektiven Emitters wird dabei die Siliziumoberfläche auf der Emitterseite so strukturiert (aufgerauht, "texturiert"), dass sich das Antireflexionsverhalten der Solarzelle verbessert.

Die Aufgabe der Erfindung ist es, ein kostengünstigeres Verfahren mit weniger Materialverlusten für das Öffnen des p-n Übergangs in Solarzellen zu finden.

Aufgabe der vorliegenden Erfindung ist es daher auch, ein einfaches, kostengünstiges, in der Solarzellenindustrie durchführbares Verfahren zur Verfügung zu stellen, durch das Siliziumoberflächen selektiv zur Erzeugung von Emittern und zur Verbesserung des Antireflexionsverhaltens geätzt werden können. Gleichzeitig ist es Aufgabe der vorliegenden Erfindung, dazu ein preiswertes Ätzmittel zur Durchführung des Ätzverfahrens zur Verfügung zu stellen.

Die Aufgabe wird insbesondere durch ein Ätzmedium zum Ätzen von Siliziumoberflächen und -schichten in Form einer verdickten, alkalischen Flüssigkeit erfüllt, wobei der Ätzprozess in der alkalischen, Lösungsmittel enthaltenden Flüssigkeit erfolgt.

Die Lösung der vorliegenden Aufgabe erfolgt daher durch die Bereitstellung einer kostengünstigen Ätzpaste, die sich schnell und selektiv, z.B. mit einem Siebdrucker oder einem Dispenser, auf die zu ätzenden Stellen aufbringen lässt und somit zum einen den Ätzchemikalienverbrauch und zum anderen den Materialverlust an der Solarzelle wesentlich minimiert.

Insbesondere besteht die vorliegende Erfindung in der Verwendung eines druck- und dispensierfähigen Ätzmedium zum partiellen Entfernen dotierter Schichten von Siliziumoberflächen oder -schichten, wobei das Ätzmedium dadurch gekennzeichnet ist, dass es eine verdickte, alkalische Flüssigkeit in Form einer Ätzpaste ist, welche
a. als ätzende Komponente eine organische oder anorganische Base enthält in einer Konzentration von 30 - 40 Gew.%, bezogen auf die Gesamtmenge des Ätzmediums,
b. mindestens ein Lösungsmittel
c. Verdickungsmittel ausgewählt aus der Gruppe Hydroxylalkylguar, Xanthan Gum, Cellulose und/oder Ethyl-, Hydroxylpropyl-, Hydroxylethylcellulose, Carboxymethylcellulose, Natrium-Carboxymethylhydroxylethylcellulose, Homopolymere oder Copolymere auf der Basis funktionalisierter Vinyleinheiten der Acrylsäure, Acrylate, und Alkylmethacrylate (C₁₀-C₃₀) einzeln oder im Gemisch in einer Menge von 1,5 - 6 Gew.%, bezogen auf die Gesamtmenge des Ätzmediums, und gegebenenfalls
d. Additive wie Entschäumer, Thixotropiemittel, Verlaufsmittel, Entlüfter, Haftvermittler enthält,
und bei Temperaturen im Bereich von 70 bis 150 °C ätzend wirkt und/oder gegebenenfalls durch Energieeintrag aktivierbar ist.

Als ätzende Komponente enthält das druck- und dispensierfähigen Ätzmedium mindestens eine Komponente ausgewählt aus der Gruppe Natriumhydroxid, Kaliumhydroxid, Ammoniak, Ethanolamin, Ethylendiamin, Tetraalkylammonium-hydroxid oder eines der Gemische Ethylendiamin/Brenzcatechin oder Ethanolamin/Gallussäure.

Gegenstand der vorliegenden Erfindung sind somit die Verwendung eines Ätzmediums, welches ein Lösungsmittel ausgewählt aus der Gruppe Wasser, iso-Propanol, Diethylenglykol, Dipropylenglykol, Polyethylenglykole,1,2- Propandiol, 1,4-Butandiol, 1,3-Butandiol, Glycerin, 1,5 Pentandiol, 2-Ethyl-1-hexanol oder deren Gemische, oder ausgewählt aus der Gruppe Acetophenon, Methyl-2-hexanon, 2-Octanon, 4-Hydroxy-4- methyl-2-pentanon, 1-Methyl-2-pyrrolidon, Ethylenglycolmonobutyl- ether, Ethylenglycolmonomethylether, Triethylenglykolmonomethyl-ether, Diethylenglykolmonobuthylether, Dipropylenglykolmonome-thylether, Carbonsäureester wie [2,2-Butoxy-(Ethoxy)]-Ethylacetat, Propylencarbonat als solche oder im Gemisch in einer Menge von 10 bis 90 Gew.-%, vorzugsweise in einer Menge von 15 bis 85 Gew.-%, bezogen auf die Gesamtmenge des Mediums enthalten.
Neben diesen Komponenten können darin Additive, ausgewählt aus der Gruppe Entschäumer, Thixotropiermittel, Verlaufsmittel, Entlüfter, und Haftvermittler in einer Menge von 0 bis 2 Gew.%, bezogen auf die Gesamtmenge enthalten sein.

Gegenstand der vorliegenden Erfindung ist weiterhin ein Verfahren zum Ätzen von Siliziumoberflächen und -schichten, in dem ein erfindungsgemäßes Ätzmedium ganzflächig oder gemäß der Ätzstrukturvorlage gezielt nur an den Stellen der Oberfläche, an denen eine Ätzung erwünscht ist, aufgetragen wird und nach einer Einwirkzeit von 30 s bis 5 min wieder entfernt wird.

Zur Durchführung dieses Verfahrens wirkt das aufgetragene Ätzmedium bei einer Temperatur im Bereich von 70 bis 150 °C ein und/oder ist gegebenenfalls durch Energieeintrag aktivierbar.
Bevorzugt wird das Ätzmedium durch Wärmeeinwirkung (IR-Lampe, Heizplatte) aktiviert. Gegebenenfalls erfolgt eine Aktivierung durch Energieeintrag, vorzugsweise durch IR-Strahlung.

Um das erfindungsgemäße Medium mit den zu ätzenden Oberflächen in Kontakt zu bringen, kann es durch ein Sieb-, Schablonen-, Tampon-, Stempel-, Ink-Jet- oder manuelles Druckverfahren oder in einer Dispensiertechnik auf die zu ätzende Oberfläche aufgebracht werden.

Nach der Einwirkzeit und erfolgter Ätzung wird Ätzmedium mit einem Lösungsmittel oder einem Lösungsmittelgemisch abgespült.

Die erfindungsgemäßen Ätzmedien können verwendet werden in der Photovoltaik, Halbleitertechnik, Hochleistungselektronik, insbesondere zur Herstellung von Photodioden, Schaltkreisen, elektronischen Bauelementen oder zum Ätzen von Siliziumoberflächen und - schichten zur Trennung des p-n Übergangs in Solarzellen. Sie können zudem verwendet werden zum Ätzen von Siliziumoberflächen und -schichten zur Herstellung eines selektiven Emitters für Solarzellen, zum Ätzen von Siliziumoberflächen und -schichten von Solarzellen zur Verbesserung des Antireflexionsverhaltens, zum Ätzen von Siliziumoberflächen und -schichten in einem Verfahren zur Herstellung von Halbleiterbauelementen und deren Schaltkreisen, oder zum Ätzen von Siliziumoberflächen und -schichten in einem Verfahren zur Herstellung von Bauelementen der Hochleistungselektronik.

Neben dem beschriebenen Öffnen des p-n-Übergangs einer Solarzelle wird durch das selektive Ätzen von Silizium mit dem verwendeten Ätzmedium die Erzeugung eines selektiven (auch zweistufigen) Emitters in der Massenproduktion und die Verbesserung des Antireflexionsverhaltens der Solarzelle ermöglicht.
Damit unterscheidet sich die vorliegende Erfindung von Verfahren, in denen eine alkalische viskose Salzlösung auf z.B. Keramikteile aufgetragen und getrocknet wird (Lösungsmittel verdampft), und der eigentliche Ätzprozess in der alkalischen Schmelze bei 300-400 °C erfolgt [7].

### Gegenstand der Erfindung

Gegenstand der Erfindung ist es, Halbleiteroberflächen und -schichten, insbesondere Siliziumoberflächen und -schichten mit Ätzpasten ganzflächig zu ätzen oder selektiv zu strukturieren. Eine für die Übertragung der Ätzpaste auf die zu ätzende Fläche geeignete Technik mit hohem Automatisierungsgrad und Durchsatz ist die Druck- und Dispensiertechnik. Insbesondere die Sieb-, Schablonen-, Tampon-, Stempel-, Ink-Jet-Druckverfahren und das Dispensierverfahren sind dem Fachmann bekannt. Ein manuelles Auftragen, z.B. mit einem Pinsel/Auftragrolle, ist ebenfalls möglich.

In Abhängigkeit von der Sieb-, Schablonen-, Klischee-, Stempelgestaltung bzw. Patronen- oder Dosiergerät-Ansteuerung ist es möglich, die erfindungsgemäß beschriebenen Ätzpasten ganzflächig bzw. gemäß der Ätzstrukturvorlage selektiv nur an den Stellen aufzutragen, an denen eine Ätzung erwünscht ist. Sämtliche Maskierungs- und Lithografieschritte entfallen hierbei.

Es können damit Strukturierungsverfahren mit aufwendigem Maskieraufwand oder Verfahren wie die Laserstrukturierung wesentlich verkürzt und billiger ausgeführt bzw. technologisch störanfällige Verfahren, wie das Plasmaätzen, durch die Druck- und Dispensiertechnik abgelöst werden. Zudem kann der Ätzprozess hinsichtlich des Ätzchemikalienverbrauchs wesentlich reduziert werden, da die Ätzpaste nur an den zu ätzenden Stellen aufgetragen wird. Insbesondere bei der Trennung des p-n Übergangs in der Silizium-Solarzellenhersteltung können durch den Einsatz von Ätzpasten folgende Vorteile erzielt werden:
- Verzicht auf teure Plasmaätzanlagen
- Senkung der dabei auftretenden hohen Bruchraten der Zellen
- Minimierung des hohen Materialverlusts beim mechanischen Trennen
- Vermeidung von Oberflächendefekten

Bei der Erzeugung des selektiven Emitters mit Ätzpasten kann ebenfalls auf Oxidmaskierung und teures Plasmaätzen verzichtet werden. Durch den selektiven Auftrag der Ätzpaste wird zudem die Unterätzung der Kontaktbereiche vermieden. Da keine Maskierung, auch nicht durch siebgedruckte Metallkontaktlinien erforderlich ist, sind Ätzschäden an den Kontakten ausgeschlossen.

Außerdem ist festzustellen, dass im Gegensatz zu bisher angewandten photolithographischen, plasmachemischen und lasertechnischen Verfahren mit der erfindungsgemäßen Ätzpaste die Erzeugung eines selektiven Emitters und die Verbesserung des Antireflexionsverhaltens wesentlich kürzer und einfacher gestaltet werden können. Die Wafer werden gleichmäßig über die gesamte Oberfläche n⁺⁺-dotiert. Die Bereiche zwischen den Kontakten werden durch die Ätzpaste abgeätzt, somit n⁺-dotiert und in ihrem Antireflexionsverhalten verbessert. Mehrere Verfahrensschritte werden damit eingespart.

Der Ätzvorgang findet vorzugsweise mit Energieeintrag, z.B. in Form von Wärmestrahlung (IR-Lampe) oder per Heizplatte statt. Nach erfolgter Ätzung werden die Ätzpasten von der geätzten Fläche mit einem geeigneten Lösungsmittel oder Lösungsmittelgemisch abgespült.

Die Ätzdauer kann je nach Anwendungszweck, gewünschter Ätztiefe und/oder Kantenschärfe der Ätzstrukturen sowie der eingestellten Ätztemperatur zwischen einigen Sekunden und mehreren Minuten betragen.

Die Ätzpasten setzen sich zusammen aus:
- ätzenden Komponenten
- Lösungsmitteln
- Verdickungsmitteln
- gegebenenfalls Additive wie z.B. Entschäumer, Thixotropiermittel, Verlaufsmittel, Entlüfter, Haftvermittler

Um die Halbleiterelemente der 4. Hauptgruppe des Periodensystems wie Silizium zu ätzen, werden starke Laugen verwendet [7]. Die Ätzwirkung der erfindungsgemäß beschriebenen Ätzpasten beruht daher auf dem Einsatz von alkalischen, Silizium-ätzenden Lösungen.

Saure Ätzpasten auf HF- bzw. Fluoridbasis - wie sie für Oxide beschrieben werden [8], [9] - zeigen keine Ätzwirkung auf Silizium.

In den beschriebenen Ätzpasten können als alkalische Ätzkomponenten wässrige Lösungen aus anorganischen Laugen wie Natriumhydroxid, Kaliumhydroxid, Ammoniak oder organisch basierende, alkalische Ätzmischungen wie Ethylendiamin/Brenzcatechin, Ethanolamin/Gallussäure, Tetraalkylammoniumhydroxid oder Kombinationen aus beiden verwendet werden.

Der Anteil der eingesetzten Ätzkomponenten liegt in einem Konzentrationsbereich von 30-40 Gew %, bezogen auf die Gesamtmasse der Ätzpaste. Für solche Ätzmedien wurden Ätzraten gefunden, die eine vollständige Öffnung des p-n Übergangs und einen hohen Durchsatz ermöglichen, dabei gleichzeitig eine hohe Selektivität zeigen.

Die Ätzkomponenten sind in den Ätzpasten bei 70-150 °C wirksam. Auf Siliziumoberflächen und -schichten wurden bei Temperaturen unter 100 °C Ätztiefen unter 1 µm und bei Temperaturen über 100 °C Ätztiefen bis zu 2 - 3 µm erzielt.

Geeignete anorganische und/oder organische Lösungsmittel und/oder. Mischungen aus diesen können sein:
- Wasser
- einfache oder mehrwertige Alkohole (z.B. iso-Propanol, Diethylenglykol, Dipropylenglykol, Polyethylenglykole,1,2-Propandiol, 1,4-Butandiol, 1,3-Butandiol, Glycerin, 1,5 Pentandiol, 2-Ethyl-1-hexanol) oder deren Gemische
- Ketone (z.B. Acetophenon, Methyl-2-hexanon, 2-Octanon, 4-Hydroxy-4-methyl-2-pentanon, 1-Methyl-2-pyrrolidon)
- Ether (z.B. Ethylenglycolmonobutylether, Ethylenglycolmonomethylether, Triethylenglykolmonomethylether, Diethylenglykolmonobuthylether, Dipropylenglykolmonomethylether)
- Carbonsäureester (z.B. [2,2-Butoxy-(Ethoxy)]-Ethylacetat)
- Ester der Kohlensäure (z.B. Propylencarbonat)

Bevorzugt werden Wasser und Lösungsmittel aus der Gruppe der Ether und Ketone eingesetzt.

Als besonders gut geeignet hat sich Wasser erwiesen.

Der Anteil der Lösungsmittel liegt im Bereich von 10 - 90 Gew %, bevorzugt bei 15 - 85 Gew.- %, bezogen auf die Gesamtmasse der Ätzpaste. Als besonders geeignet haben sich Zusammensetzungen erwiesen, in denen Lösungsmittel in einer Menge von 55 -75 Gew.-% bezogen auf die Gesamtmasse der Ätzpaste enthalten sind.

Die Viskosität der erfindungsgemäß beschriebenen Ätzpasten wird durch netzwerkbildende, in der flüssigen Phase quellende Verdikkungsmittel eingestellt und lässt sich je nach gewünschtem Einsatzgebiet variieren.

Mögliche Verdickungsmittel sind vernetzte und unvernetzte Homopolymere und Copolymere, basierend auf Monomereinheiten wie funktionalisierte Vinyleinheiten, z.B. Acrylsäure, Acrylate, Alkylmethacrylate (C₁₀-C₃₀) und Hydroxylalkylguar, Xanthan Gum sowie Glukoseeinheiten, die β-glucosidisch verknüpft, d.h. Cellulose und/oder Cellulosederivate wie Celluloseether, insbesondere Ethyl-, Hydroxylpropyl-, Hydroxylethylcellulose, Carboxymethylcellulose und Salze des Glykolsäureethers der Cellulose, insbesondere Natrium-Carboxymethylcellulose. Die Verdicker können einzeln und/oder in Kombinationen mit anderen Verdickern eingesetzt werden. Bevorzugt werden Salze der Carboxymethylcellulose und vernetzte Acrylsäurepolymere als Verdickungsmittel eingesetzt. Als ganz besonders geeignet für diesen Zweck haben sich das Natriumsalz der Carboxymethylcellulose (Finnfix®) und vernetzte Acrylsäurehomopolymere (Carbomere®) erwiesen.

Der Anteil der Verdickungsmittel, der zur gezielten Einstellung des Viskositätsbereiches und zur Bildung einer druckfähigen oder dispensierfähigen Paste erforderlich ist, liegt im Bereich von 1,5-6 Gew.-% bezogen auf die Gesamtmasse der Ätzpaste.

Additive mit für den gewünschten Zweck vorteilhaften Eigenschaften sind Entschäumer, z.B. TEGO® Foamex N (Dimethylpolysiloxan), Thixotropiermittel z.B. BYK® 410 (modifizierter Harnstoff), Borchigel® Thixo2, Verlaufsmittel z.B. TEGO® Glide ZG 400 (Polyethersiloxan-Copolymer), Entlüfter z.B. TEGO® Airex 986 (Polymer mit Siliconspitze) und Haftvermittler z.B. Bayowet® FT 929 (Fluortensid). Diese können die Druck- und Dispensierfähigkeit der Ätzpaste positiv beeinflussen. Der Anteil der Additive liegt im Bereich von 0 - 2 Gew.- % bezogen auf die Gesamtmasse der Ätzpaste.

Durch Versuche wurde gefunden, dass sowohl die Auswahl der zur Herstellung der Ätzmedien eingesetzten Komponenten als auch das Mengenverhältnis der Komponenten zueinander in den Ätzmedien von erheblicher Bedeutung ist. Je nachdem, in welcher Weise die Ätzmedien auf die zu ätzende Fläche aufgebracht werden, ist das prozentuale Verhältnis der Komponenten zueinander anders einzustellen, da u. a. Viskosität und Fließfähigkeit, bzw. die sich einstellende Thixotropie erheblich durch die enthaltenen Mengen an Lösungsmittel und an Verdikkungsmittel beeinflusst werden. Die enthaltenen Mengen an Lösungs- und Verdickungsmittel wiederum beeinflussen das Ätzverhalten. Je nach Art der Verwendung im erfindungsgemäßen Verfahren ist daher dem Fachmann möglich eine entsprechend angepasste Zusammensetzung des Ätzmediums auszuwählen.

### Anwendungsgebiete

Anwendungsgebiete für die erfindungsgemäßen Ätzpasten liegen in der:
- Solarzellenindustrie
- Halbleiterindustrie
- Hochleistungselektronik

Die erfindungsgemäßen Ätzpasten können überall dort eingesetzt werden, wo eine ganzflächige und/oder strukturierte Ätzung von Siliziumoberflächen oder -schichten gewünscht wird. So können ganzflächig oder selektiv einzelne Strukturen in eine Siliziumoberfläche oder -schicht bis in die jeweils gewünschte Tiefe geätzt werden.

Anwendungsgebiete sind z.B.:
- sämtliche Ätzschritte (gleichbedeutend mit Strukturierungsschritten), inklusive Oberflächenreinigung/-aufrauhung an Siliziumoberflächen und -schichten, die zur Herstellung von optoelektrischen Bauelementen wie Solarzellen, Photodioden und dgl. führen, insbesondere sind dieses die Trennung des p-n-Übergangs in Siliziumsolarzellen und das partielle Entfernen dotierter Schichten (selektiver Emitter)
- sämtliche Ätzschritte an Siliziumoberflächen und -schichten, die zur Herstellung von Halbleiterbauelementen und Schaltkreisen führen
- sämtliche Ätzschritte an Siliziumoberflächen und -schichten, die zur Herstellung von Bauelementen der Hochleisturigselektronik (IGBT's, Leistungs-Thyristoren, GTO's, etc.)führen.

Zum besseren Verständnis und zur Verdeutlichung der Erfindung werden im folgenden Beispiele gegeben, die im Rahmen des Schutzbereiches der vorliegenden Erfindung liegen, jedoch nicht geeignet sind, die Erfindung auf diese Beispiele zu beschränken.

### Beispiele

### Beispiel 1

40,0 g KOH
59,0 g VE-Wasser
1,5 g Ethylenglykolmonobutylether
4,0 g Carbomer (Acrylsäurehomopolymer)

Die Chemikalien wurden in einem Becherglas eingewogen, gemischt, gelöst und das Verdickungsmittel unter Rühren zugegeben.

Die Abfüllung in Behälter erfolgt nach einer kurzen Standzeit. Diese Mischung ergibt eine Ätzpaste, mit welcher gezielt z.B. Siliziumoberflächen und -schichten ganzflächig bzw. in Strukturen mit und/oder ohne Energieeintrag bis zu einer gewünschten Tiefe geätzt werden kann.

Die Ätzpaste wurde z.B. siebgedruckt bzw. mit einem Dispenser (z.B. Nadeldurchmesser von 260 µm) auf die Siliziumoberfläche aufgebracht und 3 min bei 100°C auf einer Heizplatte geätzt. Bei der Erzeugung von Ätzstrukturen mit ca. 1 mm Linienbreite auf einem n-dotierten (100) Siliziumwafer beträgt die ermittelte Ätztiefe (in Abhängigkeit von Druck- und Dispensierparametern) 0,3 - 1 µm. Mit der Erhöhung der KOH-Konzentration und der Linienbreite kann die Ätztiefe gesteigert werden. Bei Linienbreiten von 4 mm und KOH-Konzentrationen von 20 - 50 Gew.-% betragen die Ätztiefen 2 - 3 µm.

Die erhaltene Ätzpaste ist lagerstabil, leicht zu handhaben und druckfählg. Sie kann mit einem Lösungsmittel, z.B. mit Wasser von der bedruckten Oberfläche oder Schicht bzw. vom Pastenträger (Sieb, Rakel, Schablone, Stempel, Klischee, Patrone usw.) entfernt werden.
[1] W. Wettling, Phys. Bl. 12 (1997), S.1197-1202
[2] J. Horzel, J. Slufzik, J. Nijs, R. Mertens, Proc. 26th IEEE PVSC, (1997), S. 139-42
[3] M. Schnell, R. Lüdemann, S. Schäfer, Proc. 16thEU PVSEC, (2000), S. 1482-85
[4] D.S. Ruby, P. Yang, S. Zaidi, S. Brueck, M. Roy, S. Narayanan, Proc. 2nd World Conference and Exhibition on PVSEC, (1998), S. 1460-63
[5] US 6,091,021 (2000), D.S. Ruby, W.K. Schubert, J.M. Gee, S.H. Zaidi
[6] US 5,871,591 (1999), D.S. Ruby, J.M. Gee, W.K. Schubert
[7] EP 0229915 (1986), M. Bock, K. Hermann, H.-J. Middeke, D. Tenbrink
[8] WO 00/40518 (1998), M. Luly, R. Singh, C. Redmon, J. Mckown, R. Pratt
[9] DE 10101926 (2000), S. Klein, L. Heider, C. Zielinski, A. Kübelbeck, W. Stockum
[10] A.F. Bogenschütz, Ätzpraxis für Halbleiter, Carl Hanser Verlag, München 1967

## Patentansprüche

1. Verwendung eines druck- und dispensierfähigen Ätzmediums zum partiellen Entfernen dotierter Schichten von Siliziumoberflächen oder -schichten, wobei das Ätzmedium **dadurch gekennzeichnet ist, dass** es eine verdickte, alkalische Flüssigkeit in Form einer Ätzpaste ist, welche
a. als ätzende Komponente eine organische oder anorganische Base enthält in einer Konzentration von 30 - 40 Gew.-%, bezogen auf die Gesamtmenge des Ätzmediums, .
b. mindestens ein Lösungsmittel
c. Verdickungsmittel ausgewählt aus der Gruppe Hydroxylalkylguar, Xanthan Gum, Cellulose und/oder Ethyl-, Hydroxylpropyl-, Hydroxylethylcellulose, Carboxymethylcellulose, Natrium-Carboxymethylhydroxylethylcellulose, Homopolymere oder Copolymere auf der Basis funktionalisierter Vinyleinheiten der Acrylsäure, Acrylate, und Alkylmethacrylate (C₁₀-C₃₀) einzeln oder im Gemisch in einer Menge von 1,5 - 6 Gew.-%, bezogen auf die Gesamtmenge des Ätzmediums, und gegebenenfalls
d. Additive wie Entschäumer, Thixotropiemittel, Verlaufsmittel, Entlüfter, Haftvermittler
enthält,
und bei Temperaturen im Bereich von 70 bis 150 °C ätzend wirkt und/oder gegebenenfalls durch Energieeintrag aktivierbar ist.

2. Verwendung eines Ätzmediums gemäß Anspruch 1, welches als ätzende Komponente mindestens eine Komponente ausgewählt aus der Gruppe Natriumhydroxid, Kallumhydroxid, Ammoniak, Ethanolamin, Ethylendiamin, Tetraalkylammonium-hydroxid oder eines der Gemische Ethylendiamin/Brenzcatechin oder Ethanolamin/Gallussäure enthält.

3. Verwendung eines Ätzmediums gemäß Anspruch 2, welches ein Lösungsmittel enthält, ausgewählt aus der Gruppe Wasser, iso-Propanol, Diethylenglykol, Dipropylenglykol, Polyethylenglykole,1,2-Propandiol, 1,4-Butandiol, 1,3-butandiol, Glycerin, 1,5 Pentandiol, 2-Ethyl-1-hexanol oder deren Gemische, oder ausgewählt aus der Gruppe Acetophenon, Methyl-2-hexanon, 2-Octanon, 4-Hydroxy-4-methyl-2-pentanon, 1-Methyl-2-pyrrolidon, Ethylenglycolmonobutylether, Ethylenglycolmonomethylether, Triethylenglykolmonomethylether, Diethylenglykolmonobuthylether, Dipropylenglykolmonomethylether, Carbonsäureester wie [2,2-Butoxy-(Ethoxy)]-Ethylacetat und Propylencarbonat als solches oder im Gemisch in einer Menge von 10 bis 90 Gew.-%, vorzugsweise In einer Menge von 15 bis 85 Gew.-%, bezogen auf die Gesamtmenge des Mediums.

4. Verwendung eines Ätzmediums gemäß Anspruch 1, **dadurch gekennzeichnet, dass** es Additive, ausgewählt aus der Gruppe Entschäumer, Thixotropiermittel, Verlaufsmittel, Entlüfter, und Haftvermittler in einer Menge von 0 bis 2 Gew.-%, bezogen auf die Gesamtmenge enthält.

5. Verfahren zum Ätzen von Siliziumoberflächen und -schichten, **dadurch gekennzeichnet, dass** ein Ätzmedium gemäß der Ansprüche 1-4 ganzflächig oder gemäß der Ätzstrukturvorlage gezielt nur an den Stellen der Oberfläche, an denen eine Ätzung erwünscht ist, aufgetragen wird und nach einer Einwirkzeit von 30 s bis 5 min wieder entfernt wird.

6. Verfahren gemäß Anspruch 5, **dadurch gekennzeichnet, dass** das Ätzmedium bei einer Temperatur im Bereich von 70 bis 150 °C einwirkt und/oder gegebenenfalls durch Energieeintrag aktiviert wird.

7. Verfahren gemäß Anspruch 6, **dadurch gekennzeichnet, dass** das Ätzmedium durch Wärmeeinwirkung (IR-Lampe, Heizplatte) aktiviert wird.

8. Verfahren gemäß Anspruch 5, **dadurch gekennzeichnet, dass** das Ätzmedium durch ein Sieb-, Schablonen-, Tampon-, Stempel-, Ink-Jet- oder manuelles Druckverfahren oder in einer Dispensiertechnik auf die zu ätzende Oberfläche aufgebracht wird.

9. Verfahren gemäß Anspruch 5, **dadurch gekennzeichnet, dass** das Ätzmedium nach erfolgter Ätzung mit einem Lösungsmittel oder einem Lösungsmittelgemisch abgespült wird.

10. Verwendung eines Ätzmediums gemäß der Ansprüche 1-4 In der Photovoltalk, Halbleitertechnik, Hochleistungselektronik sowie zur Herstellung von Photodioden, Schaltkreisen, elektronischen Bauelementen.

11. Verwendung gemäß der Ansprüche 1-4 zum Ätzen von Siliziumoberflächen und -schichten zur Trennung des p-n Übergangs in Solarzellen.

12. Verwendung gemäß der Ansprüche 1-4 zum Ätzen von Siliziumoberflächen und -schichten zur Herstellung eines selektiven Emitters für Solarzellen.

13. Verwendung gemäß der Ansprüche 1-4 zum Ätzen von Siliziumoberflächen und -schichten von Solarzellen zur Verbesserung des Antireflexionsverhaltens.

14. Verwendung gemäß der Ansprüche 1-4 zum Ätzen von Siliziumoberflächen und -schichten in einem Verfahren zur Herstellung von Halbleiterbauelementen und deren Schaltkreisen.

15. Verwendung gemäß der Ansprüche 1-4 zum Ätzen von Siliziumoberflächen und -schichten in einem Verfahren zur Herstellung von Bauelementen der Hochleistungselektronik.

## Claims

1. Use of a printable and dispensable etching medium for the partial removal of doped layers from silicon surfaces or layers, where the etching medium is **characterised in that** it is a thickened, alkaline liquid in the form of an etching paste which comprises
a. as etching component, an organic or inorganic base in a concentration of 30 - 40% by weight, based on the total amount of the etching medium,
b. at least one solvent,
c. thickeners selected from the group hydroxyalkylguar, xanthan gum, cellulose and/or ethyl-, hydroxypropyl-, hydroxyethylcellulose, carboxymethylcellulose, sodium carboxymethylhydroxyethylcellulose, homopolymers or copolymers based on functionalised vinyl units of acrylic acid, acrylates and alkyl methacrylates (C₁₀-C₃₀), individually or in a mixture in an amount of 1.5 - 6% by weight, based on the total amount of the etching medium,
and optionally
d. additives, such as antifoams, thixotropic agents, flow-control agents, deaerators, adhesion promoters,
and has an etching action at temperatures in the range from 70 to 150°C and/or can optionally be activated by the input of energy.

2. Use of an etching medium according to Claim 1, which comprises, as etching component, at least one component selected from the group sodium hydroxide, potassium hydroxide, ammonia, ethanolamine, ethylenediamine, tetraalkylammonium hydroxide or one of the mixtures ethylenediamine/pyrocatechol or ethanolamine/gallic acid.

3. Use of an etching medium according to Claim 2, which comprises a solvent selected from the group water, isopropanol, diethylene glycol, dipropylene glycol, polyethylene glycols, 1,2-propanediol, 1,4-butanediol, 1,3-butanediol, glycerol, 1,5-pentanediol, 2-ethyl-1-hexanol or mixtures thereof, or selected from the group acetophenone, methyl-2-hexanone, 2-octanone, 4-hydroxy-4-methyl-2-pentanone, 1-methyl-2-pyrrolidone, ethylene glycol monobutyl ether, ethylene glycol monomethyl ether, triethylene glycol monomethyl ether, diethylene glycol monobutyl ether, dipropylene glycol monomethyl ether, carboxylic acid esters, such as [2,2-butoxy(ethoxy)]ethyl acetate and propylene carbonate, as such or in a mixture in an amount of 10 to 90% by weight, preferably in an amount of 15 to 85% by weight, based on the total amount of the medium.

4. Use of an etching medium according to Claim 1, **characterised in that** it comprises additives selected from the group antifoams, thixotropic agents, flow-control agents, deaerators and adhesion promoters in an amount of 0 to 2% by weight, based on the total amount.

5. Method for the etching of silicon surfaces and layers, **characterised in that** an etching medium according to Claims 1-4 is applied over the entire area or in accordance with the etch structure mask specifically only to the areas of the surface where etching is desired and is removed again after an exposure time of 30 s to 5 min.

6. Method according to Claim 5, **characterised in that** the etching medium acts at a temperature in the range from 70 to 150°C and/or is optionally activated by the input of energy.

7. Method according to Claim 6, **characterised in that** the etching medium is activated by exposure to heat (IR lamp, hotplate).

8. Method according to Claim 5, **characterised in that** the etching medium is applied to the surface to be etched by a screen, template, pad, stamp, ink-jet or manual printing process or in a dispensing technique.

9. Method according to Claim 5, **characterised in that** the etching medium is rinsed off using a solvent or solvent mixture when the etching is complete.

10. Use of an etching medium according to Claims 1-4 in photovoltaics, semiconductor technology, high-performance electronics and for the production of photodiodes, switching circuits, electronic components.

11. Use according to Claims 1-4 for the etching of silicon surfaces and layers for isolation of the p-n junction in solar cells.

12. Use according to Claims 1-4 for the etching of silicon surfaces and layers for the production of a selective emitter for solar cells.

13. Use according to Claims 1-4 for the etching of silicon surfaces and layers of solar cells for improving the antireflection behaviour.

14. Use according to Claims 1-4 for the etching of silicon surfaces and layers in a process for the production of semiconductor components and switching circuits thereof.

15. Use according to Claims 1-4 for the etching of silicon surfaces and layers in a process for the production of components in high-performance electronics.

## Revendications

1. Utilisation d'un milieu de décapage imprimable et distribuable pour l'élimination partielle de couches dopées depuis des surfaces ou couches en silicium, où le milieu de décapage est **caractérisé en ce qu'**il s'agit d'un liquide alcalin épaissi sous forme d'une pâte de décapage qui comprend
a. comme composant de décapage, une base organique ou inorganique en une concentration de 30 - 40% en poids, par rapport à la quantité totale du milieu de décapage,
b. au moins un solvant,
c. des épaississants sélectionnés dans le groupe constitué par l'hydroxyalkyl guar, la gomme de xanthane, la cellulose et/ou l'éthyl-, l'hydroxypropyl-, l'hydroxyéthylcellulose, la carboxyméthylcellulose, la carboxyméthylhydroxyéthylcellulose de sodium, les homopolymères ou copolymères à base d'unités vinyliques fonctionnalisées de l'acide acrylique, d'acrylates et de méthacrylates d'alkyle (C₁₀-C₃₀), individuellement ou en mélange selon une quantité de 1,5 - 6% en poids, par rapport à la quantité totale du milieu de décapage,
et éventuellement
d. des additifs, tels que des antimousses, des agents thixotropes, des régulateurs d'écoulement, des agents de désaération, des promoteurs d'adhérence,
et présente une action de décapage à des températures dans le domaine de 70 à 150°C et/ou peut éventuellement être activé par la fourniture d'énergie.

2. Utilisation d'un milieu de décapage selon la revendication 1, qui comprend, comme composant de décapage, au moins un composant sélectionné dans le groupe constitué par l'hydroxyde de sodium, l'hydroxyde de potassium, l'ammoniac, l'éthanolamine, l'éthylènediamine, l'hydroxyde de tétraalkylammonium ou l'un des mélanges d'éthylènediamine/pyrocatéchol ou d'éthanolamine/acide gallique.

3. Utilisation d'un milieu de décapage selon la revendication 2, qui comprend un solvant sélectionné dans le groupe constitué par l'eau, l'isopropanol, le diéthylène glycol, le dipropylène glycol, les polyéthylène glycols, le 1,2-propanediol, le 1,4-butanediol, le 1,3-butanediol, le glycérol, le 1,5-pentanediol, le 2-éthyl-1-hexanol ou des mélanges de ceux-ci, ou sélectionné dans le groupe constitué par l'acétophénone, la méthyl-2-hexanone, la 2-octanone, la 4-hydroxy-4-méthyl-2-pentanone, la 1-méthyl-2-pyrrolidone, l'éthylène glycol monobutyléther, l'éthylène glycol monométhyléther, le triéthylène glycol monométhyléther, le diéthylène glycol monobutyléther, le dipropylène glycol monométhyléther, les esters d'acides carboxyliques, tels que l'acétate de [2,2-butoxy(éthoxy)]éthyle et le carbonate de propylène, tels quels ou dans un melange selon une quantité de 10 à 90% en poids, de préférence selon une quantité de 15 à 85% en poids, par rapport à la quantité totale du milieu.

4. Utilisation d'un milieu de décapage selon la revendication 1, **caractérisée en ce qu'**il comprend des additifs sélectionnés dans le groupe constitué par les antimousses, les agents thixotropes, les régulateurs d'écoulement, les agents de désaération et les promoteurs d'adhérence, selon une quantité de 0 à 2% en poids, par rapport à la quantité totale.

5. Méthode de décapage de surfaces et de couches en silicium, **caractérisée en ce qu'**un milieu de décapage selon les revendications 1-4 est appliqué sur toute la surface ou, selon le masque de la structure de décapage, spécifiquement seulement aux endroits de la surface où un décapage est désiré, et est éliminé de nouveau après un temps d'exposition allant de 30 s à 5 min.

6. Méthode selon la revendication 5, **caractérisée en ce que** le milieu de décapage agit à une température dans le domaine de 70 à 150°C et/ou est éventuellement activé par la fourniture d'énergie.

7. Méthode selon la revendication 6, **caractérisée en ce que** le milieu de décapage est activé par une exposition à la chaleur (lampe IR, plaque chauffante).

8. Méthode selon la revendication 5, **caractérisée en ce que** le milieu de décapage est appliqué sur la surface à décaper par un procédé d'impression par sérigraphie, par gabarit, au tampon, par estampage, au jet d'encre ou manuel, ou dans une technique de distribution.

9. Méthode selon la revendication 5, **caractérisée en ce que** le milieu de décapage est rincé en utilisant un solvant ou un mélange de solvants une fois le décapage terminé.

10. Utilisation d'un milieu de décapage selon les revendications 1-4 dans le photovoltaïque, la technologie des semi-conducteurs, l'électronique haute performance et pour la production de photodiodes, de circuits de commutation, de composants électroniques.

11. Utilisation selon les revendications 1-4, destinée au décapage de surfaces et de couches en silicium pour l'isolement de la jonction p-n dans les cellules solaires.

12. Utilisation selon les revendications 1-4, destinée au décapage de surfaces et de couches en silicium pour la production d'un émetteur sélectif pour les cellules solaires.

13. Utilisation selon les revendications 1-4, destinée au décapage de surfaces et de couches en silicium de cellules solaires afin d'améliorer le comportement antireflet.

14. Utilisation selon les revendications 1-4, destinée au décapage de surfaces et de couches en silicium dans un procédé de production de composants de semi-conducteurs et de circuits de commutation de ceux-ci.

15. Utilisation selon les revendications 1-4, destinée au décapage de surfaces et de couches en silicium dans un procédé de production de composants pour l'électronique haute performance.
